# EUROPÄISCHE PATENTSCHRIFT

(11) **EP 2 721 637 B1**
(45) Veröffentlichungstag und Bekanntmachung des Hinweises auf die Patenterteilung: **04.01.2017**
(21) Anmeldenummer: 12727624.4
(22) Anmeldetag: 30.05.2012
(51) Int. Cl.: H01L 23/36, H01L 23/373, H01L 23/433

(54) **ELEKTRONISCHE SCHALTUNGSANORDNUNG MIT VERLUSTWÄRME ABGEBENDEN KOMPONENTEN**
ELECTRONIC CIRCUIT ARRANGEMENT HAVING COMPONENTS EMITTING LOST HEAT
CIRCUITERIE ÉLECTRONIQUE COMPORTANT DES COMPOSANTS QUI DISSIPENT DE LA CHALEUR PERDUE

(30) Priorität: 17.06.2011 DE 102011077675; 24.05.2012 DE 102012208767
(43) Veröffentlichungstag der Anmeldung: 23.04.2014
(73) Patentinhaber: Robert Bosch GmbH, 70442 Stuttgart (DE)
(72) Erfinder: GROMALA, Przemyslaw, Jakub, 72764 Reutlingen (DE)
(86) Internationale Anmeldenummer: PCT/EP2012/060160
(87) Internationale Veröffentlichungsnummer: WO 2012/171797

(56) Entgegenhaltungen:
- EP-A1- 1 873 827
- EP-A1- 2 224 484
- DE-B3-102008 009 510
- US-A1- 2008 079 145
- US-A1- 2008 101 032
- US-A1- 2010 102 431
- US-A1- 2010 133 681
- US-A1- 2010 252 922

## Beschreibung

### Stand der Technik

Die Erfindung betrifft eine elektronische Schaltungsanordnung mit Verlustwärme abgebenden Komponenten eines Schaltungsmoduls. Die Komponenten sind auf einem Schaltungsträger angeordnet und in eine Kunststoffgehäusemasse eingebettet, welche den Schaltungsträger mindestens teilweise umgibt. Die Kunststoffgehäusemasse und der Schaltungsträger weisen unterschiedliche thermische Ausdehnungskoeffizienten auf. Das Schaltungsmodul aus Kunststoffgehäusemasse und Schaltungsträger mit Verlustwärme abgebenden Komponenten ist federelastisch auf einer Wärmesenke fixiert.

Aus der Druckschrift US 2006/0007652 A1 ist eine Schraubenfeder bekannt, um ein elektronisches Gerät, wie ein Schaltungsmodul, auf eine Oberseite einer Wärmesenke mit mindestens nahezu gleichförmigen Druck zu pressen, wodurch die Wärmesenke in der Lage ist, effektiv Wärme von dem elektronischen Schaltungsmodul ohne Beschädigung des Schaltungsmoduls abzuziehen. Die Federelemente sind dazu auf Längsseiten eines Rahmens angeordnet, der flächig Wärmesenken auf Komponenten eines Schaltungsträgers presst.

Aus der Druckschrift US2010/252922 A1 ist ein Wärmeleiterelement aus einer Schicht aus Wärmeleitpaste bekannt, die in der Lage ist, einer Verwölbung des Substrats zu folgen.

Aus der Druckschrift US2010/102431 A1 ist ein Invertermodul für den Einsatz in einem Kraftfahrzeug bekannt, in dem ein Halbleiterchip auf einem Substrat aufgebracht ist, welches über eine Lotschicht mit einem Entwärmungselement verbunden ist.

Druckschrift EP2224484 A1 offenbart ein Halbleitermodul, in dem zwischen einem Keramiksubstrat mit Metallbeschichtung und einem Kühlkörper eine segmentförmige Entspannungsschicht aus Aluminium ausgebildet ist.

Außerdem ist aus der Druckschrift US 5,010,949 ein Federelement bekannt, das eine Wärmesenke auf ein Schaltungsmodul mit hoher Dichte von integrierten Schaltungen presst, wobei das Schraubenfederelement ein Formgedächtnismaterial aufweist und eine zusätzliche Federkraft auf eine Fixierung zwischen einer Oberseite einer Wärmesenke und einer Unterseite des Schaltungsmoduls ausübt, wenn eine vorgegebene Temperatur von dem Schaltungsmodul überschritten wird. Das Formgedächtnismaterial des Schraubenfederelements dient lediglich dazu, den Anpressdruck der Wärmesenke auf das Schaltungsmodul mit Überschreitung der Temperaturschwelle zu erhöhen.

### Offenbarung der Erfindung

Mit der Erfindung wird eine Schaltungsanordnung mit Verlustwärme abgebenden Komponenten eines Schaltungsmoduls vorgeschlagen, wobei die Komponenten auf einem Schaltungsträger angeordnet und in eine Kunststoffgehäusemasse eingebettet sind, welche den Schaltungsträger mindestens teilweise umgibt. Die Kunststoffgehäusemasse und der Schaltungsträger weisen unterschiedliche thermische Ausdehnungskoeffizienten auf. Das Schaltungsmodul aus Kunststoffgehäusemasse und Schaltungsträger mit Verlustwärme abgebenden Komponenten ist federelastisch auf einer Wärmesenke fixiert. Zwischen der Wärmesenke und dem Schaltungsmodul ist ein wärmeleitendes Entwärmungselement angeordnet. Das Entwärmungselement ist unterschiedlichen Verwölbungen des Schaltungsmoduls bei unterschiedlichen Betriebstemperaturen angepasst.

Beim Betrieb des Moduls aus einem Schaltungsträger mit den Verlustwärme abgebenden Komponenten und einer die Komponenten einbettenden Kunststoffgehäusemasse, die mindestens teilweise den Schaltungsträger umgibt, kann sich das Modul aufgrund der unterschiedlichen thermischen Ausdehnungskoeffizienten von Kunststoffgehäusemasse und Schaltungsträger verwölben. Eine derartige Verwölbung des Schaltungsmoduls kann je nach Betriebstemperaturbereich des Schaltungsmoduls dieses konkav oder konvex verformen. Dadurch kann sich ein mediengefüllter Spalt zwischen dem Entwärmungselement und dem Schaltungsmodul partiell um ein Vielfaches der ursprünglichen Spaltbreite vergrößern. Aufgrund der partiellen Vergrößerung des Spaltes zwischen Schaltungsmodul und wärmeleitendem Entwärmungselement vergrößert sich der Wärmewiderstand des Mediums, wie Luft, Öl oder nachgiebigem Klebstoff, bzw. vermindert sich partiell die Wärmeleitfähigkeit des mediengefüllten Spaltes bei Ausbildung derartiger Verwölbungen des Schaltungsmoduls, was zu Überhitzungen einzelner Verlustwärme abgebender Komponenten führen kann. Durch die erfindungsgemäße Anpassung der Form des Entwärmungselements an die Verwölbung des Schaltungsmoduls kann dafür gesorgt werden, dass diesem Effekt entgegengewirkt wird.

Der Schaltungsträger kann beispielsweise eine Leiterplatte z.B. ein PCB ("printed circuit board") oder LTTC, DBC oder FR4 oder andere standardisierte, typische Substrate der Halbleitertechnologie aufweisen. Weiterhin können die Schaltungsträger auch mehrlagige Keramiken aufweisen.

Das Entwärmungselement kann zur Anpassung seiner Form an eine Verwölbung des Schaltungsmoduls bei einem ersten Aspekt der Erfindung ein Formgedächtnismaterial aufweisen, dessen Formgedächtnis den temperaturabhängigen Verwölbungen des Schaltungsmoduls angepasst ist. Das Formgedächtnismaterial kann als plattenförmiges, wärmeleitendes Entwärmungselement zwischen der Wärmesenke und dem Schaltungsmodul angeordnet sein und ein bidirektionales Formgedächtnismaterial in Plattenform aufweisen.

Ein derartiges bidirektionales Formgedächtnismaterial aus einer Metalllegierung kann in Abhängigkeit von der Betriebstemperatur sowohl eine konkave als auch eine konvexe Form in einem vorbestimmten Übergangstemperaturbereich von einem ersten Metallgefügezustand zu einem zweiten Metallgefügezustand wie beispielsweise von einem martensitischen Gefüge in ein austenitisches Gefüge und umgekehrt übergehen. Dabei kann durch die Plattendicke des Formgedächtnismaterials das Entwärmungselement den Verwölbungen des Schaltungsmoduls angepasst sein.

Bei einem zweiten Aspekt der Erfindung kann ein plattenförmiges Entwärmungselement segmentiert sein. Die Segmente des Entwärmungselements können auf der Oberfläche der Wärmesenke derart beweglich oder kippbar angeordnet sein, dass sie einer Verwölbung einer Unterseite des Schaltungsmoduls folgen können. Dazu kann jedes der Segmente des Entwärmungselements ein Positionierungselement aufweisen, das mit einem Arretierungselement auf der Wärmesenke in Eingriff steht.

Dabei ist es möglich, dass das Positionierungselement eine Aussparung auf einer Unterseite des Segmentes und das Arretierungselement der Wärmesenke eine Erhebung auf einer Oberseite der Wärmesenke aufweisen. Die Aussparung auf der Unterseite des Segmentes kann mit der Erhebung auf der Oberseite der Wärmesenke formschlüssig in Eingriff stehen, so dass keine Platzverschiebung der einzelnen Segmente des Entwärmungselements möglich ist, jedoch eine Verkippung und Ausrichtungsänderung der Segmente zur Anpassung sowohl an eine konkave als auch an eine konvexe Verwölbung des Schaltungsmoduls bereitgestellt wird.

Formschlüssig zueinander passende Erhebungen und Aussparungen können auch umgekehrt vorgesehen werden, so dass das Positionierungselement auf der Unterseite des Segmentes als Erhebung ausgebildet ist und das Arretierungselement auf der Oberseite der Wärmesenke als Aussparung vorbereitet ist. Als Erhebung können Schweiß- oder Löttropfen auf eine Oberseite oder Unterseite aufgebracht sein oder es können halbkugelförmige Elemente aufgeschweißt, galvanisch abgeschieden oder als Löttropfen auf entsprechende Metallflächen aufgebracht sein. Dabei können die Erhebungen eine Kugelform, eine Halbkugelform oder ein sonstiges erhabenes Element ausbilden. Auch kann als Erhebung ein Nietkopf oder ein Einpresspin vorgesehen sein.

Anstelle derartiger Erhebungen und Aussparungen ist es auch möglich, zwischen einem plattenförmigen Segment des Entwärmungselements und der Oberseite der Wärmesenke jeweils mindestens ein Federelement anzuordnen, wobei jedes Federelement das entsprechende Segment des Entwärmungselements gegen die verwölbte Unterseite des Schaltungsmoduls presst.

Weiterhin ist es vorgesehen, dass das Segment oder die Wärmesenke oder beide an korrespondierenden Positionen an das Federelement angepasste Aussparungen aufweisen. Diese Aussparungen sorgen dafür, dass die Federelemente ihre Positionen unter den Segmenten beibehalten. Die Federelemente können auch dazu mit einem Ende an der Unterseite des Segmentes oder an der Oberseite der Wärmesenke stoffschlüssig fixiert sein, während das andere Ende das Federelements in eine der vorgesehenen Aussparungen eingepasst ist. Als Federelemente können alle Arten von Druckfedern, wie Schraubenfedern, Schenkelfedern, Wiegefedern oder vergleichbare Federelemente, vorgesehen werden.

Die Erfindung kann auf ein Schaltungsmodul einer Getriebe- oder Motorsteuereinheit eines Kraftfahrzeugs angewandt werden, wobei der Schaltungsträger des Schaltungsmoduls beispielsweise eine Schaltungsplatine mit Leiterbahnen umfasst. Auf dem Schaltungsträger können ein oder mehrere elektronische Bauelemente als Komponenten einschließlich elektronischer Schaltungen wie ICs ("integrated circuits"), Mikroprozessorchips, Logikchips, integrierte Halbleiterchips und/oder passive elektronische Komponenten, wie Widerstände, Kondensatoren oder Induktivitäten oder aktive Steuerelemente wie Transistoren usw. angeordnet sein. Der Schaltungsträger kann auch einen Flachleiterrahmen aufweisen, auf dem Verlustwärme abgebende Komponenten, wie integrierte Schaltungen mit Leistungstransistoren zur Leistungsversorgung, Mikroprozessoren oder Logikschaltungen, vorgesehen sind, wobei der Flachleiterrahmen in einer Kunststoffgehäusemasse eingebettet ist, aus der Flachleiteranschlüsse als Außenkontakte des Schaltungsmoduls herausragen.

Eine Wärmesenke für eine derartige Getriebe- oder Motorsteuereinheit eines Kraftfahrzeugs kann ein metallisches Karosserieteil, ein Getriebegehäuse oder ein wassergekühltes Verbrennungsmotorgehäuse eines Kraftfahrzeugs bilden. Die thermische Verbindung zu dem Schaltungsmodul kann durch die Anordnung des erfindungsgemäßen Entwärmungselements optimiert werden. Das Entwärmungselement kann sich an Verwölbungen des Schaltungsmoduls selbsttätig anpassen.

### Vorteile der Erfindung

Mit der Erfindung ist der Vorteil verbunden, dass der sich beim federelastischen Fixieren des Schaltungsmoduls auf einer Oberseite einer Wärmesenke in Form eines Karosserieteils eines Getriebegehäuses oder eines wassergekühlten Verbrennungsmotorgehäuses eines Fahrzeugs ausbildende mediengefüllte Spalt, der sich bei unterschiedlichen Betriebsbedingungen und Temperaturen des Fahrzeugs durch Verwölbungen des Schaltungsmoduls partiell vergrößert, durch das Entwärmungselement thermisch kompensiert wird. Durch die Anpassungsfähigkeit des Entwärmungselements zwischen der Wärmesenke und dem Schaltungsmodul kann der Spalt zwischen Schaltungsmodul und Entwärmungselement auf ein Minimum einer Spaltbreite zwischen verwölbtem Schaltungsmodul und angepasstem Entwärmungselement reduziert werden. Wärme, die aus dem Schaltungsmodul abgeführt werden muss, kann somit in optimaler Weise von dem Schaltungsmodul auf die zusätzliche Wärmesenke, die das Entwärmungselement bildet, übertragen und von dem Schaltungsträger abgeführt werden.

Das in mehrere Segmentplatten segmentierte Entwärmungselement kann flexibel auf Verwölbungen eines Schaltungsmoduls, bestehend aus Schaltungsträger mit Verlustwärme abgebenden Komponenten, reagieren, indem es seine Form derart anpasst, dass sich trotz Ausbildung von Verwölbungen des Schaltungsmoduls ein nahezu gleichmäßig verminderter, mediengefüllter Spalt zwischen dem Entwärmungselement und dem Schaltungsmodul bildet.

Mit der Erfindung können Erwärmungsspitzen der Komponenten aufgrund der zusätzlichen Wärmekapazität des Entwärmungselements und der relativ gleich bleibenden Wärmeleitung zwischen dem Schaltungsmodul und dem Entwärmungselement, trotz Verwölbung des Schaltungsmoduls, ausgeglichen werden.

Durch das Selbstanpassen des Entwärmungselements kann die Gefahr einer lokalen Überhitzung des Schaltungsmoduls vermindert werden, da der Wärmetransport von der in Kunststoffmasse eingebetteten, elektronischen Steuereinheit eines Getriebes oder Verbrennungsmotors durch das Entwärmungselement, das zwischen der elektronischen Steuereinheit in Form eines Schaltungsmoduls und der Wärmesenke in Form eines wärmeleitenden Karosserieteils oder eines wärmeleitenden Gehäuses eines Getriebes oder eines wassergekühlten Verbrennungsmotors angeordnet ist, verbessert wird, zumal das formanpassbare Entwärmungselement die Verwölbungen des Schaltungsmoduls, die während der Temperaturzyklen auftreten, kompensiert.

Ein in mehrere Segmente aufgeteiltes Entwärmungselement aus einem Material mit hohem Wärmeleitungskoeffizient stellt eine zusätzliche Wärmesenke dar, die den Verwölbungen des Schaltungsmoduls folgt, wobei die plattenförmigen Segmente des Entwärmungselements auf dem Getriebe- oder Verbrennungsmotorgehäuse auf den Erhebungen, sphärischen Buckeln oder Serien von Federn angeordnet sein können, so dass in vorteilhafter Weise Ausrichtungen des Entwärmungselements aus einzelnen Segmentplatten während der Temperaturänderungen derart geändert werden können, dass die Wärmeübertragungsbedingungen jederzeit optimiert bleiben.

Weiterhin ist es von Vorteil bei einer federelastischen Vorspannung der Segmente des Entwärmungselements, dass jede einzelne Feder für ein einzelnes Segment des Entwärmungselements in einer Aussparung entweder auf der Oberseite der Wärmesenke oder auf der Unterseite des einzelnen wärmeleitenden Segmentes des Entwärmungselements angeordnet ist und somit die Federelemente ihre Positionen auch beim Ändern von Betriebsbedingungen beibehalten.

Von Vorteil ist eine weitere Optimierung durch Einsatz von Formgedächtnismaterialien für das plattenförmige Entwärmungselement, zumal bidirektionale Formgedächtnismaterialien sowohl konkave als auch konvexe Verformungen bei vorgegebenen Übergangstemperaturbereichen einnehmen und damit den Spalt zwischen einem konkav oder konvex verwölbtem Schaltungsmodus in optimaler Weise minimieren können.

### Kurze Beschreibung der Zeichnungen

Weitere Aspekte und Vorteile der Erfindung werden nunmehr anhand der beigefügten Figuren eingehender beschrieben. Hierbei zeigt:
- Fig. 1: eine perspektivische Skizze einer Schaltungsanordnung einer ersten Ausführungsform der Erfindung;
- Fig. 2: einen schematischen Querschnitt durch die Schaltungsanordnung gemäß Fig. 1 vor dem Auftreten einer Verwölbung;
- Fig. 3: einen schematischen Querschnitt durch die Schaltungsanordnung gemäß Fig. 1 nach Auftreten einer Verwölbung bei einer ersten Temperatur;
- Fig. 4: einen schematischen Querschnitt durch die Schaltungsanordnung gemäß Fig. 1 nach Auftreten einer Verwölbung bei einer zweiten Temperatur;
- Fig. 5: einen schematischen Querschnitt durch die Schaltungsanordnung gemäß einer zweiten Ausführungsform der Erfindung;
- Fig. 6: einen schematischen Querschnitt durch die Schaltungsanordnung gemäß Fig. 5 nach Auftreten einer Verwölbung bei einer ersten Temperatur;
- Fig. 7: einen schematischen Querschnitt durch die Schaltungsanordnung gemäß Fig. 5 nach Auftreten einer Verwölbung bei einer zweiten Temperatur;
- Fig. 8: eine perspektivische Skizze einer Schaltungsanordnung einer dritten Ausführungsform der Erfindung;
- Fig. 9: einen schematischen Querschnitt durch die Schaltungsanordnung gemäß Fig. 8 nach Auftreten einer Verwölbung bei einer ersten Temperatur;
- Fig. 10: einen schematischen Querschnitt durch die Schaltungsanordnung gemäß Fig. 8 nach Auftreten einer Verwölbung bei einer zweiten Temperatur.

### Ausführungsformen der Erfindung

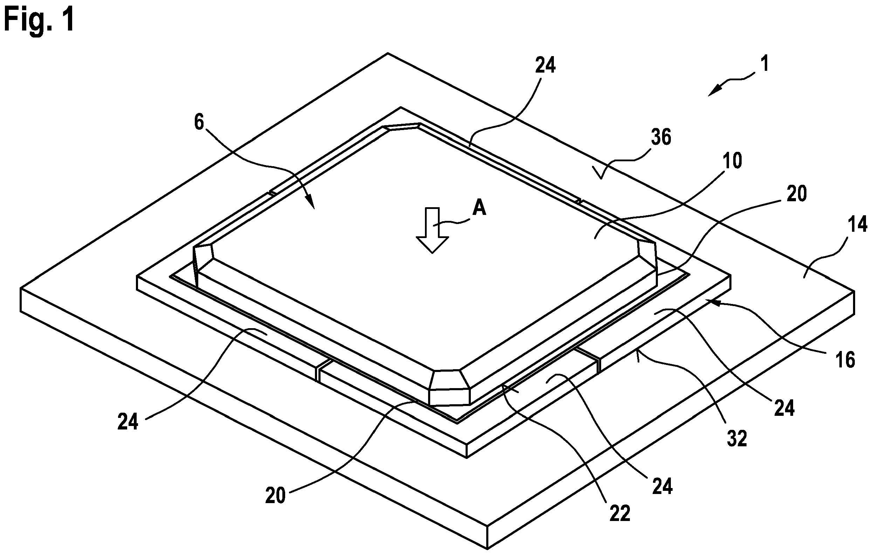

Die in Figur 1 gezeigte perspektivische Skizze einer Schaltungsanordnung 1 einer ersten Ausführungsform der Erfindung weist ein Schaltungsmodul 6 auf, von dem hier lediglich die Außenumrisse des Kunststoffgehäuses aus einer Kunststoffgehäusemasse 10 zu sehen sind. Zwischen dem Schaltungsmodul 6 und einem Entwärmungselement 16 bildet sich normalerweise ein mediengefüllter Spalt 20 aus, wobei ein derartiger Spalt 20 lediglich einige 10 µm dick ist und ein Medium wie Luft, Öl oder nachgiebigem Klebstoff aufweisen kann. Das Entwärmungselement 16 weist eine höhere Wärmekapazität und eine höhere Wärmleitfähigkeit als das Schaltungsmodul 6 auf und ist aus einer Metalllegierung hergestellt.

In dieser ersten Ausführungsform der Erfindung ist das plattenförmige Entwärmungselement 16 in vier Segmente 24 aufgeteilt, die gegenüber einer Oberseite 36 einer Wärmesenke kippbar angeordnet sind, so dass sich die Entwärmungssegmente 24 durch Verkippen an eine Verwölbung auf der Unterseite 22 des Schaltungsmoduls 6 anpassen können. In Pfeilrichtung A wird auf das Schaltungsmodul 6 ein Federdruck ausgeübt, der das Schaltungsmodul 6 auf das plattenförmige Entwärmungselement 16 als eine erste Wärmesenke presst. Das Entwärmungselement 16 wird wiederum mit seinen Entwärmungssegmenten 24 auf die Oberseite 36 einer zweiten größeren Wärmesenke 14 beispielsweise in Form eines Karosserieteils oder eines Getriebegehäuses oder eines wassergekühlten Verbrennungsmotors eines Kraftfahrzeugs gepresst. Trotz dieser in Pfeilrichtung A wirkenden Federkraft kann sich das Schaltungsmodul 6 verwölben, da die Kunststoffgehäusemasse 10 einen von einer als Schaltungsträger eingesetzten Schaltungsplatine unterschiedlichen thermischen Ausdehnungskoeffizienten aufweist.

Aufgrund des unterschiedlichen thermischen Ausdehnungskoeffizienten zwischen Kunststoffgehäusemasse und dem umhüllten Schaltungsträger 8 können Verwölbungen auftreten, die den in Figur 1 gezeigten mediengefüllten Spalt 20 partiell deutlich vergrößern und den Spalt in den, die Verwölbung umgebenden Bereichen vermindern. Durch eine Spaltvergrößerung erhöht sich automatisch in dieser Region der thermische Widerstand im Spalt bei gleichzeitig sinkender thermischer Leitfähigkeit, womit die Gefahr verbunden ist, dass es zu partiellen thermischen Überhitzungen auf dem Schaltungsträger und von einzelnen Komponenten kommen kann. Mit den nachfolgenden Figuren werden Ausführungsformen gezeigt, bei denen sich die Form des in Figur 1 gezeigten plattenförmigen Entwärmungselements den Auswölbungen optimal anpassen kann.

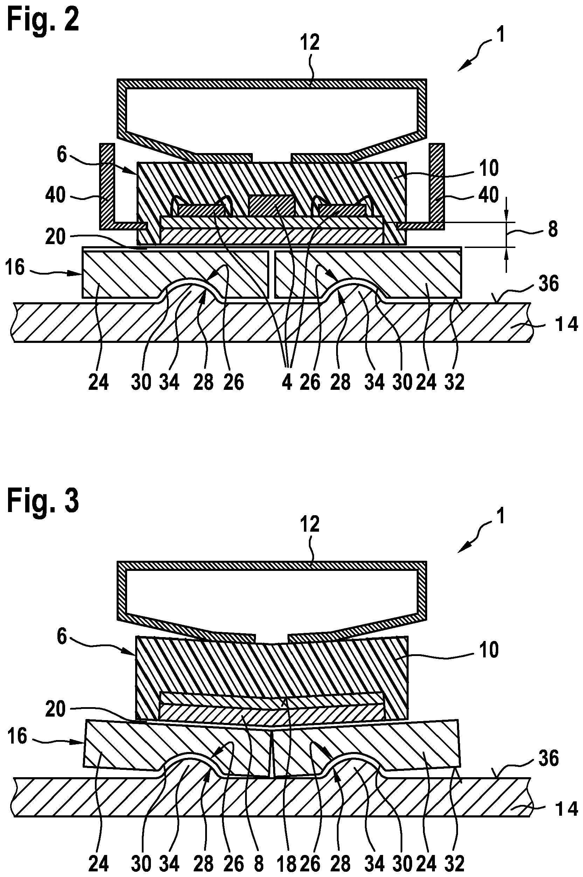

Figur 2 zeigt einen schematischen Querschnitt durch die Schaltungsanordnung 1 gemäß Figur 1 vor dem Auftreten einer Verwölbung. Ein Federelement 12 presst das Schaltungsmodul 6 unter Ausbildung eines mediengefüllten Spaltes 20 auf das Entwärmungselement 16, das Verlustwärmespitzen der auf einem mehrlagigen Schaltungsträger 8 angeordneten Komponenten 4, soweit es seine Wärmekapazität zulässt, aufnehmen und vermindern kann. Außerdem liegt das Entwärmungselement 16 mit seiner Unterseite 32 auf einer größeren Wärmesenke 14, die beispielsweise ein wärmeleitendes Karosserieteil oder ein Getriebegehäuse oder ein wassergekühltes Verbrennungsmotorgehäuse sein kann. Das Schaltungsmodul weist in dieser Ausführungsform eine Getriebe- oder Motorschalteinheit auf, die über aus der Kunststoffgehäusemasse 10 abgewinkelt herausragende Flachleiterkontakte 40 Steuersignale abgeben kann. Wie Figur 2 zeigt, wird das Schaltungsmodul 6 mithilfe eines Federelements 12 auf das segmentierte Entwärmungselement 16 und dieses wiederum auf die Wärmesenke 14 oder ein Karosserieteil gepresst.

In dieser ersten Ausführungsform der Erfindung gemäß Figur 2 ist das Entwärmungselement 16 in einzelne Segmente 24 segmentiert, wie es bereits Figur 1 gezeigt hat. Jedes Segment weist auf seiner Unterseite 32 eine Aussparung 30 auf, die als Positionierelement 26 dient. Auf der Oberseite 36 der Wärmesenke 14 sind im Bereich der Positionierelemente 26 Arretierungselemente 28 in Form von Erhebungen 34 angeordnet, die beispielsweise durch galvanisches Aufbringen oder durch Auflöten oder Aufschweißen auf die Oberseite 36 der Wärmesenke 14 aufgebracht sind.

Figur 3 zeigt einen schematischen Querschnitt durch die Schaltungsanordnung 1 gemäß Figur 1 nach Auftreten einer Verwölbung 18 bei einer ersten Temperatur. Bei dieser ersten Temperatur tritt eine konvexe Verwölbung des Schaltungsmoduls 6 auf, wodurch die plattenförmigen Entwärmungssegmente 24 des Entwärmungselements 16 auf den Arretierungselementen 28 gekippt werden und damit die mediengefüllte Spaltbreite des Spaltes 20 nicht wesentlich vergrößern, da sich die Segmente 24 durch ihre Verkippung an die konvexe Verwölbung des Schaltungsmoduls 6 anpassen können.

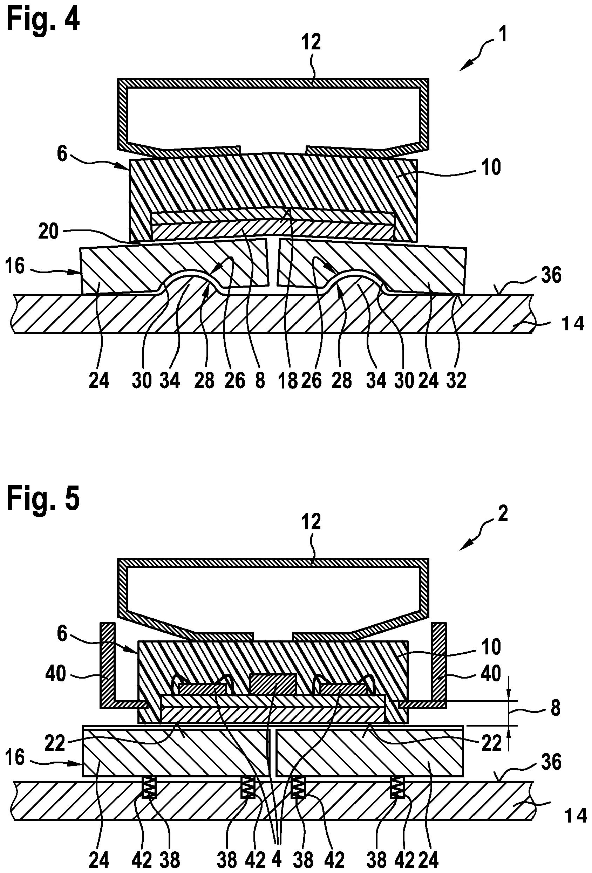

Figur 4 zeigt einen schematischen Querschnitt durch die Schaltungsanordnung 1 gemäß Figur 1 nach Auftreten einer Verwölbung bei einer zweiten Temperatur. Bei dieser zweiten Temperatur tritt eine konkave Verwölbung des Schaltungsmoduls 6 auf. Auch hier ist es durch die Segmentierung des Entwärmungselements 16 möglich, den mediengefüllten Spalt 20 zwischen dem Entwärmungselement 16 bzw. den Segmenten 24 des Entwärmungselements 16 und der konkaven Verwölbung des Schaltungsmoduls 6 gering zu halten.

Figur 5 zeigt einen schematischen Querschnitt durch eine Schaltungsanordnung 2 gemäß einer zweiten Ausführungsform der Erfindung, wobei Komponenten mit gleichen Funktionen wie in den vorhergehenden Figuren mit gleichen Bezugszeichen gekennzeichnet und nicht extra erörtert werden. Der Unterschied zu der vorhergehenden Ausführungsform gemäß den Figuren 1 bis 4 besteht darin, dass die Wärme aufnehmenden Segmente 24 des Entwärmungselements 16 federelastisch vorgespannt sind, indem beispielsweise in entsprechenden Federsitzen 42 der Wärmesenke 14 Federelemente 38 unter Vorspannung angeordnet sind, so dass bei einer Verwölbung die Federelemente 38 die Segmente 24 des Entwärmungselements 16 gegen die Unterseite 22 des Schaltungsmoduls 6 pressen können.

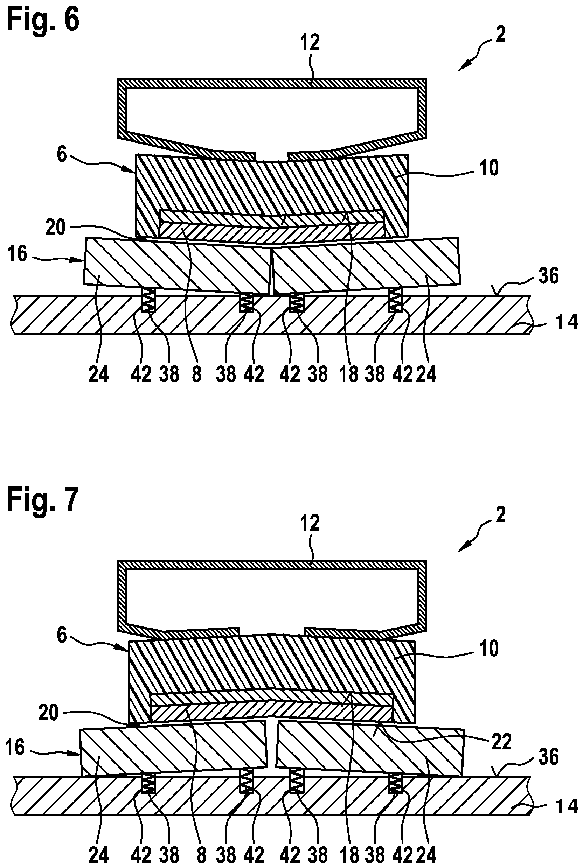

Das wird mit der Figur 6 deutlich, in der ein schematischer Querschnitt durch die Schaltungsanordnung 2 gemäß Figur 5 nach Auftreten einer Verwölbung 18 bei einer ersten Temperatur gezeigt wird. Aufgrund der konvexen Verwölbung 18 werden die Segmente 24 mittels äußerer randseitiger Federelemente 38 stärker angehoben als durch die Federelemente 38, die im Zentrum angeordnet sind. Dadurch wird erreicht, dass der mediengefüllte Spalt 20 eine minimale Breite trotz der konvexen Verwölbung 18 aufweist.

Figur 7 zeigt einen entsprechenden schematischen Querschnitt durch die Schaltungsanordnung 2 gemäß Figur 5 nach Auftreten einer konkaven Verwölbung 18 bei einer zweiten Temperatur und verdeutlicht, dass hier die Federelemente 38 die Segmente 24 des Entwärmungselements 16 derart anheben können, dass wiederum ein geringer mediengefüllter Spalt 20 auftritt und eine optimale Wärmekopplung zwischen dem Schaltungsmodul 6 und dem Entwärmungselement 16 möglicht wird.

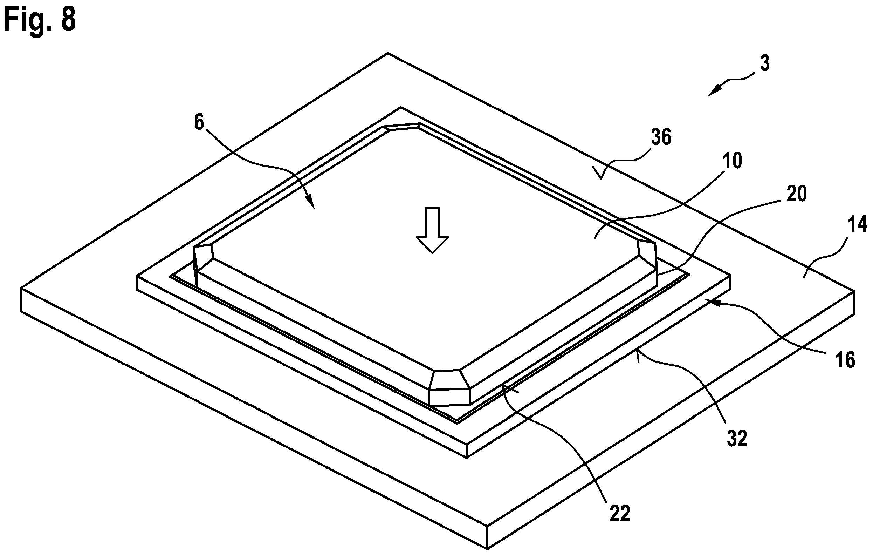

Figur 8 zeigt eine perspektivische Skizze einer Schaltungsanordnung 3 einer dritten Ausführungsform der Erfindung. Dabei weist bei dieser dritten Ausführungsform der Erfindung das plattenförmige Entwärmungselement 16 keine Segmentierung auf. Dennoch passt sich das Entwärmungselement 16 automatisch den Verwölbungen bei unterschiedlichen Betriebstemperaturen des Schaltungsmoduls 6 an, da das Entwärmungselement 16 aus einem bidirektionalen Formgedächtnismaterial besteht. Dieses Formgedächtnismaterial hat den Vorteil, dass es in einem Übergangsbereich von einer Ausgangsform in eine entgegen gesetzte Form übergehen kann, wobei in dem Temperaturübergangsbereich das Material von einer ersten Gefügestruktur in eine zweite Gefügestruktur übergehen kann, wie beispielsweise bei Eisenlegierungen von einem martensitischen Gefüge in ein austenitisches Gefüge und umgekehrt.

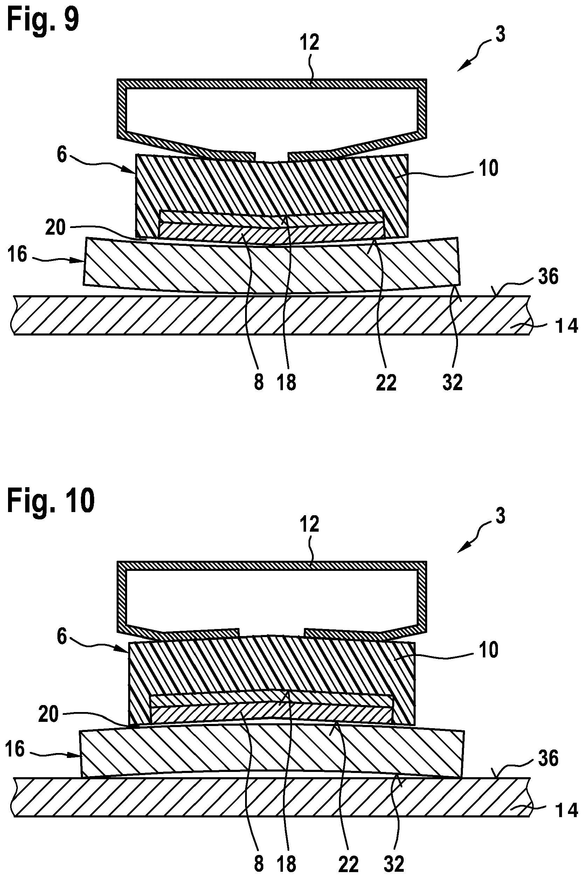

Wie Figur 9 in einem schematischen Querschnitt zeigt, ist damit die Möglichkeit geschaffen, nach Auftreten einer Verwölbung bei einer ersten Temperatur, die das Schaltungsmodul 6 konvex verwölbt, dass das Entwärmungselement 16 eine konvexe Form annimmt und damit den mediengefüllten Spalt 20 minimiert.

Umgekehrt kann bei einer zweiten Temperatur, wie Figur 10 zeigt, mit einer konkaven Verwölbung des Schaltungsmoduls 6 auch das plattenförmige Entwärmungselement 16 eine derartig konkave Kontur annehmen und wiederum den mediengefüllten Spalt 20 zwischen Schaltungsmodul 6 und Entwärmungselement 16 minimieren.

## Patentansprüche

1. Elektronische Schaltungsanordnung mit Verlustwärme abgebenden Komponenten (4) eines Schaltungsmoduls (6) und mit
- einem Schaltungsträger (8), auf dem die Komponenten (4) angeordnet sind;
- einer Kunststoffgehäusemasse (10), in welche die Komponenten (4) eingebettet sind, wobei die Kunststoffgehäusemasse (10) den Schaltungsträger (8) mindestens teilweise umgibt und die Kunststoffgehäusemasse (10) und der Schaltungsträger (8) unterschiedliche thermische Ausdehnungskoeffizienten aufweisen;
- mindestens einem Federelement (12), mit dem das Schaltungsmodul (6) aus Kunststoffgehäusemasse (10) und Schaltungsträger (8) federelastisch auf einer Wärmesenke (14) fixiert ist,
wobei ein wärmeleitendes Entwärmungselement (16) zwischen der Wärmesenke (14) und dem Schaltungsmodul (6) angeordnet ist, und wobei das Entwärmungselement (16) Verwölbungen (18) des Schaltungsmoduls (6) bei unterschiedlichen Betriebstemperaturen angepasst ist,
dadurch charakterisiert, dass das Entwärmungselement (16) ein wärmeleitendes Formgedächtnismaterial aufweist, dessen Formgedächtnis den temperaturabhängigen Verwölbungen (18) des Schaltungsmoduls (6) angepasst ist, oder das Entwärmungselement (16) segmentiert ist, und die Segmente (24) des Entwärmungselements (16) kippbar auf einer Oberfläche (36) der Wärmesenke (14) angeordnet sind.

2. Schaltungsanordnung nach Anspruch 1,
wobei die Schaltungsanordnung (1, 2) zwischen dem Entwärmungselement (16) und dem Schaltungsmodul (6) einen mediengefüllten Spalt (20) aufweist.

3. Schaltungsanordnung nach Anspruch 1 oder 2,
wobei das Formgedächtnismaterial einen Übergangstemperaturbereich von einem ersten zu einem zweiten kristallinen Zustand aufweist und dabei eine Formänderung ausbildet, die der Verwölbung (18) des Schaltungsmoduls (6) angepasst ist.

4. Schaltungsanordnung nach Anspruch 1 oder 2,
wobei jedes Segment (24) des Entwärmungselements (16) ein Positionierungselement (26) aufweist, das mit einem Arretierungselement (28) auf der Wärmesenke (14) in Eingriff steht.

5. Schaltungsanordnung nach Anspruch 4,
wobei das Positionierungselement (26) eine Aussparung (30) auf einer Unterseite (32) des Segmentes (24) und das Arretierungselement (28) der Wärmesenke (14) eine Erhebung (34) auf einer Oberseite (36) der Wärmesenke (14) aufweisen, und wobei die Aussparung (30) und die Erhebung (34) formschlüssig in Eingriff stehen.

6. Schaltungsanordnung nach Anspruch 1 oder 2,
wobei zwischen einem Segment (24) und der Oberseite (36) der Wärmesenke (14) ein Federelement (38) angeordnet ist, und wobei das Federelement (38) das Segment (24) des Entwärmungselements (16) gegen die Unterseite (22) des Schaltungsmoduls (6) presst.

7. Schaltungsanordnung nach einem der vorhergehenden Ansprüche,
wobei das Schaltungsmodul (6) eine Getriebe- oder Motorsteuereinheit eines Kraftfahrzeugs mit Mikroprozessorchips, Logikchips, integrierten Halbleiterchips und/oder passiven elektronischen Komponenten, wie Widerständen, Kondensatoren oder Induktivitäten auf einer Schaltungsplatine als Schaltungsträger (8) aufweist.

8. Schaltungsanordnung nach einem der vorhergehenden Ansprüche,
wobei die Wärmesenke (14) ein metallisches Karosserieteil, ein Getriebegehäuse oder ein wassergekühltes Verbrennungsmotorgehäuse eines Kraftfahrzeugs ist.

## Claims

1. Electronic circuit arrangement with components (4) of a circuit module (6) that emit lost heat and with
- a circuit carrier (8), on which the components (4) are arranged;
- a plastic housing mass (10), in which the components (4) are embedded, the plastic housing mass (10) at least partially surrounding the circuit carrier (8) and the plastic housing mass (10) and the circuit carrier (8) having different coefficients of thermal expansion;
- at least one spring element (12), with which the circuit module (6) comprising the plastic housing mass (10) and the circuit carrier (8) is fixed resiliently on a heat sink (14),
a heat-conducting cooling element (16) being arranged between the heat sink (14) and the circuit module (6), and the cooling element (16) being adapted to distortions (18) of the circuit module (6) at different operating temperatures, **characterized in that** the cooling element (16) comprises a heat-conducting shape memory material, the shape memory of which is adapted to the temperature-dependent distortions (18) of the circuit module (6), or the cooling element (16) is segmented, and the segments (24) of the cooling element (16) are arranged tiltably on a surface (36) of the heat sink (14).

2. Circuit arrangement according to Claim 1, the circuit arrangement (1, 2) having a media-filled gap (20) between the cooling element (16) and the circuit module (6).

3. Circuit arrangement according to Claim 1 or 2,
the shape memory material having a transition temperature range from a first crystalline state to a second crystalline state and thereby forming a change in shape that is adapted to the distortion (18) of the circuit module (6).

4. Circuit arrangement according to Claim 1 or 2,
each segment (24) of the cooling element (16) having a positioning element (26), which is in engagement with an arresting element (28) on the heat sink (14).

5. Circuit arrangement according to Claim 4,
the positioning element (26) having a recess (30) on an underside (32) of the segment (24) and the arresting element (28) of the heat sink (14) having an elevation (34) on an upper side (36) of the heat sink (14), and the recess (30) and the elevation (34) being in form-fitting engagement.

6. Circuit arrangement according to Claim 1 or 2,
a spring element (38) being arranged between a segment (24) and the upper side (36) of the heat sink (14), and the spring element (38) pressing the segment (24) of the cooling element (16) against the underside (22) of the circuit module (6).

7. Circuit arrangement according to one of the preceding claims,
the circuit module (6) having a gearbox or engine control unit of a motor vehicle with microprocessor chips, logic chips, integrated semiconductor chips and/or passive electronic components, such as resistors, capacitors or inductances on a circuit board as the circuit carrier (8).

8. Circuit arrangement according to one of the preceding claims,
the heat sink (14) being a metal body part, a gearbox housing or a water-cooled combustion engine housing of a motor vehicle.

## Revendications

1. Système de circuit électronique comportant des composants (4) d'un module de circuit (6), qui dissipent de la chaleur perdue, et comportant
- un support de circuit (8) sur lequel sont disposés les composants (4) ;
- une masse (10) formant enveloppe en matière plastique dans laquelle les composants (4) sont incorporés, dans lequel la masse (10) formant enveloppe en matière plastique entoure au moins partiellement le support de circuit (8) et la masse (10) formant enveloppe en matière plastique et le support de circuit (8) présentent des coefficients de dilatation thermique différents ;
- au moins un élément élastique (12), au moyen duquel le module de circuit (6) constitué de la masse (10) formant enveloppe en matière plastique et du support de circuit (8), est fixé de manière élastique à un puits thermique (14),
dans lequel un élément extracteur de chaleur thermiquement conducteur (16) est disposé entre le puits thermique (14) et le module de circuit (6), et dans lequel l'élément extracteur de chaleur (16) épouse des courbures (18) du module de circuit (6) à des températures de fonctionnement différentes,
**caractérisé en ce que** l'élément extracteur de chaleur (16) comporte un matériau à mémoire de forme thermiquement conducteur, dont la mémoire de forme est adaptée aux courbures (18) liées à la température du module de circuit (6), ou bien l'élément extracteur de chaleur (16) est segmenté et les segments (24) de l'élément extracteur de chaleur (16) sont disposés de manière à pouvoir être inclinés sur une surface (36) du puits thermique (14).

2. Système de circuit selon la revendication 1, dans lequel le système de circuit (1, 2) présente une encoche (20) remplie d'agent entre l'élément d'extraction de chaleur (16) et le module de circuit (6).

3. Système de circuit selon la revendication 1 ou 2, dans lequel le matériau à mémoire de forme présente une plage de températures de transition d'un premier à un second état cristallin et crée ainsi une modification de forme qui est adaptée à la courbure (18) du module de circuit (6).

4. Système de circuit selon la revendication 1 ou 2, dans lequel chaque segment (24) de l'élément extracteur de chaleur (16) comporte un élément de positionnement (26) qui est en prise avec un élément de butée (28) sur le puits thermique (14).

5. Système de circuit selon la revendication 4, dans lequel l'élément de positionnement (26) présente un évidement (30) sur une face inférieure (32) du segment (24) et l'élément de butée (28) du puits thermique (14) présente une protubérance (34) sur une face supérieure (36) du puits thermique (14), et dans lequel l'évidement (30) et la protubérance (34) sont en prise l'un avec l'autre par complémentarité de forme.

6. Système de circuit selon la revendication 1 ou 2, dans lequel un élément à ressort (38) est disposé entre un segment (24) et la face supérieure (36) du puits thermique (14) et dans lequel l'élément à ressort (38) comprime le segment (24) de l'élément extracteur de chaleur (16) contre la face inférieure (22) du module de circuit (6).

7. Système de circuit selon l'une quelconque des revendications précédentes, dans lequel le module de circuit (6) comporte une unité de commande de transmission ou de moteur d'un véhicule automobile munie d'une puce de microprocesseur, d'une puce logique, d'un circuit à semi-conducteur intégré et/ou de composants électroniques passifs tels que des résistances, des condensateurs ou des inductances, sur une carte de circuit imprimé en tant que support de circuit (8).

8. Système de circuit selon l'une quelconque des revendications précédentes, dans lequel le puits thermique (14) est une partie de carrosserie métallique, un carter de transmission ou un carter de moteur à combustion refroidi à l'eau d'un véhicule automobile.
